# EUROPEAN PATENT SPECIFICATION

(11) **EP 1 045 452 B1**
(45) Date of publication and mention of the grant of the patent: **12.02.2003**
(21) Application number: 98954720.3
(22) Date of filing: 18.11.1998
(51) Int. Cl.: H01L 31/02, H01L 27/14, H01J 31/49

(54) **PHOTODETECTOR AND IMAGE PICKUP DEVICE EMPLOYING IT**
PHOTODETEKTOR UND BILDAUFNAHMEVORRICHTUNG MIT DIESEM PHOTODETEKTOR
PHOTODETECTEUR ET DISPOSITIF DE PRISE D'IMAGE UTILISANT LEDIT PHOTODETECTEUR

(30) Priority: 19.11.1997 JP 31848997
(43) Date of publication of application: 18.10.2000
(73) Proprietor: Hamamatsu Photonics K.K., Shizuoka-ken 435-8558 (JP)
(72) Inventor: HAKAMATA, Naotaka, Hamamatsu-shi, Shizuoka-ken 435-8558 (JP); MARUNO, Tadashi, Hamamatsu-shi, Shizuoka-ken 435-8558 (JP); SUYAMA, Motohiro, Hamamatsu-shi, Shizuoka-ken 435-8558 (JP)
(74) Representative: Brown, Kenneth Richard
(86) International application number: PCT/JP98/05179
(87) International publication number: WO 99/026298

(56) References cited:
- EP-A- 0 565 366
- JP-A- 6 216 402
- JP-A- 8 255 921
- JP-A- 9 162 379
- JP-A- 9 199 075
- JP-A- 49 106 380
- US-A- 3 177 363
- US-A- 4 178 529
- US-A- 4 464 572
- US-A- 5 485 005
- PATENT ABSTRACTS OF JAPAN vol. 008, no. 190 (E-263), 31 August 1984 (1984-08-31) & JP 59 080056 A (FUJITSU KK), 9 May 1984 (1984-05-09)
- PATENT ABSTRACTS OF JAPAN vol. 012, no. 228 (E-627), 28 June 1988 (1988-06-28) & JP 63 019978 A (LEO GIKEN:KK), 27 January 1988 (1988-01-27)
- PATENT ABSTRACTS OF JAPAN vol. 1998, no. 14, 31 December 1998 (1998-12-31) & JP 10 256613 A (FUJI PHOTO FILM CO LTD), 25 September 1998 (1998-09-25)
- PATENT ABSTRACTS OF JAPAN vol. 1996, no. 08, 30 August 1996 (1996-08-30) & JP 08 107526 A (OLYMPUS OPTICAL CO LTD), 23 April 1996 (1996-04-23)

## Description

### Technical Field

The present invention relates to a photodetecting device having a photodetecting section including a photoelectric surface for converting incident light into photoelectrons and a semiconductor detection element for detecting the photoelectrons emitted from the photoelectric surface, and an image sensing apparatus using the photodetecting device.

### Background Art

Conventionally, a vacuum tube type photodetecting device is known which has a photodetecting section having a photoelectric surface for emitting photoelectrons upon incidence of light and an electron incidence type semiconductor detection element for converting the photoelectrons emitted from the photoelectric surface into a signal voltage. As an example of a photodetecting device of this type, an electron tube is disclosed in Japanese Patent Laid-Open No. 6-243795. The electron tube disclosed in this prior art has a photoelectric surface and a back irradiation type CCD opposing the photoelectric surface. This electron tube can detect weak light or UV light, unlike a camera which has no photoelectric surface and makes light directly incident on a semiconductor detection element such as a CCD.

Another known photodetecting device is that disclosed in US 4,178,529 in which upon incidence of light on a photoelectric circuit photoelectrons are released and directed onto an electron incident surface within a vacuum vessel, and cooling means for cooling the semiconductor detection element side of the vacuum vessel. However, such device is subject to condensation within its housing.

### Disclosure of the Invention

In recent years, however, demand has arisen for further improvement of the photodetecting efficiency of photodetecting devices represented by the electron tube disclosed in Japanese Patent Laid-Open No. 6-243795, which has a photodetecting section including a photoelectric surface and an electron incidence type semiconductor detection element.

The present invention has been made in consideration of the above situation, and has as its object to provide a photodetecting device with an improved photodetecting efficiency and an image sensing apparatus using the photodetecting device.

To achieve this object, the present inventors have completed the present invention with an emphasis on a technique for reducing a dark current flowing to the photoelectric surface and the semiconductor detection element such as a CCD.

In accordance with the present invention there is provided a photodetecting device comprising a housing, light transparent means located on the housing for allowing the passage of light into the housing, the housing including vacuum means for evacuating the housing to a vacuum state, photodetecting means located within the housing so as to receive thereon light passing through the light transparent means and to emit photoelectrons from a photoelectric surface thereof in accordance with the amount of light incident thereon, a semiconductor detection element including an electron incident surface spaced from and facing photoelectric surface of the photodetecting means for receiving photoelectrons emitted from the photodetecting means so as to emit an electrical signal in accordance with the amount of photoelectrons incident upon the semiconductor detection element, a voltage terminal mounted on the housing being electrically connected to the photo detecting means for applying a high voltage between the photoelectric surface and the electron incident surface of the semiconductor detection element, cooling means for cooling the semiconductor detection element, the said cooling means including a heat absorption portion for absorbing heat and a heat generation portion for generating heat, characterised by said heat absorption portion being arranged on the semiconductor detection element and said heat generation portion of said cooling means being fixed at a predetermined position on an inner surface of said housing; and by a gas introduction part through which a dry inert gas has been introduced into said housing, said dry inert gas being sealed in the housing at a pressure lower than atmospheric pressure.

In the photodetecting device of the present invention, when measurement light becomes incident on the photoelectric surface, photoelectrons are emitted. When the photoelectrons are incident on the electron incident surface of the semiconductor detection element, the incident light is detected. In the present invention, the structure on the semiconductor detection element side of the vacuum vessel is cooled, and therefore, a dark current in the semiconductor detection element is suppressed. Not only the semiconductor detection element but also the photoelectric surface is cooled through the vacuum vessel in which the semiconductor detection element and photoelectric surface are arranged. Hence, a dark current in the photoelectric surfaces is also suppressed, and the photodetecting efficiency is improved.

In the photodetecting device of the present invention, preferably, the cooling means has an absorption portion for absorbing heat and a heat generation portion for generating heat, and the heat absorption portion is arranged on the semiconductor detection element side of the vacuum vessel. As such cooling means, a Peltier element is preferably used.

When this arrangement is employed, for example, the absorption portion of the cooling means such as a Peltier element absorbs heat of the semiconductor detection element. The semiconductor detection element is cooled, and the dark current is suppressed. Not only heat of the semiconductor detection element but also heat of the photoelectric surface is absorbed by the absorption portion of the cooling means through the vacuum vessel. The photoelectric surface is cooled, and the dark current is suppressed.

Preferably, the photodetecting device further comprises a housing which comprises a transparent portion capable of passing the light to be incident on the photoelectric surface, and a voltage introduction terminal capable of supplying, to the photodetecting section, a voltage to be applied between the photoelectric surface and the electron incident surface, and accommodates at least part of the vacuum vessel, and the heat generation portion of the cooling means is fixed at a predetermined position on an inner surface of the housing.

When this arrangement is employed, for example, incident light transmitted through the transparent portion made of glass reaches the photoelectric surface, and photoelectrons are generated by the photoelectric surface. When a voltage is applied between the photoelectric surface and the electron incident surface from a voltage supply source outside the housing through the voltage introduction terminal, the photoelectrons generated by the photoelectric surface are attracted by the electron incident surface. With this operation, the incident light is detected. In addition, since the heat generation portion of the cooling means is fixed at a predetermined position on an inner surface of the housing, heat generated by the heat generation portion of the cooling means is transmitted to the transparent portion through the housing. For this reason, the transparent portion is not excessively cooled, and condensation on the transparent portion is prevented. Hence, the efficiency of measurement light reaching the photoelectric surface, and more specifically, the photodetecting efficiency of the photodetecting device is improved.

When the arrangement with the housing having the transparent portion and voltage introduction terminal is employed, the housing preferably further comprises a vacuum port for setting a vacuum state in the housing.

In this case, the vacuum state is set in the housing by exhausting the gas from the housing through the vacuum port using a vacuum pump or the like. When the vacuum state is set in the housing, the cooling efficiency of the photoelectric surface and semiconductor detection element is improved, and discharge between the voltage introduction terminal and the housing can be prevented.

When the arrangement with the housing having the transparent portion and voltage introduction terminal is employed, the housing preferably further comprises a gas introduction port for introducing and sealing a dry inert gas having a pressure lower than atmospheric pressure in the housing.

In this case, since the gas sealed in the housing is a dry gas, condensation in the housing is prevented. Hence, the efficiency of incident light reaching the photoelectric surface is prevented from lowering due to condensation. Additionally, since the gas is an inert gas with a pressure lower than atmospheric pressure, discharge between the voltage introduction terminal and the housing can be prevented.

The housing further preferably further comprises radiation means for radiating heat, the radiation means being arranged at the predetermined position where the heat generation portion of the cooling means is fixed.

When this arrangement is employed, heat generated by the heat generation portion of the cooling means is externally radiated from the housing by the radiation means. Hence, the cooling efficiency of the vacuum vessel is improved, and the dark current flowing to the photoelectric surface and semiconductor detection element is further reduced.

The vacuum vessel may comprise an incident surface plate which passes the light and has the photoelectric surface arranged on one surface, a detection element fixing plate opposing the incident surface plate and having the semiconductor detection element arranged thereon, and a side tube which forms a vacuum space together with the incident surface plate and the detection element fixing plate.

When this arrangement is employed, the semiconductor detection element is cooled by the vacuum vessel through the detection element fixing plate. Since the incident surface plate on which the photoelectric surface is arranged is connected to the detection element fixing plate through the side tube, not only the semiconductor detection element but also the photoelectric surface is cooled by thermal conduction.

Especially, when the side tube and detection element fixing plate are formed from a ceramic material having a high thermal conductivity, the thermal conductivity is improved, and the photoelectric surface can be easily cooled as the semiconductor detection element is cooled.

### Brief Description of the Drawings

Fig. 1 is a sectional view of a photodetecting device according to a first embodiment;
Fig. 2 is a sectional view of the photodetecting device shown in Fig. 1, which is taken along a line II - II;
Fig. 3 is a graph showing the relationship between gas pressure and flashover voltage;
Fig. 4 is a graph showing the relationship between the type of gas and the cooling temperature;
Fig. 5 is a graph showing the relationship between the elapsed time and the cooling temperature when xenon gas is sealed;
Fig. 6 is a sectional view of a photodetecting device according to the second embodiment;
Fig. 7 is a sectional view of a photodetecting device according to the third embodiment; and
Fig. 8 is a view showing the arrangement of a CCD camera as an image sensing apparatus.

### Best Mode of Carrying Out the Invention

Preferred embodiments of a photodetecting device according to the present invention will be described below in detail with reference to the accompanying drawings. The same reference numerals denote the same elements throughout the drawings, and a repetitive description thereof will be omitted.

### [First Embodiment]

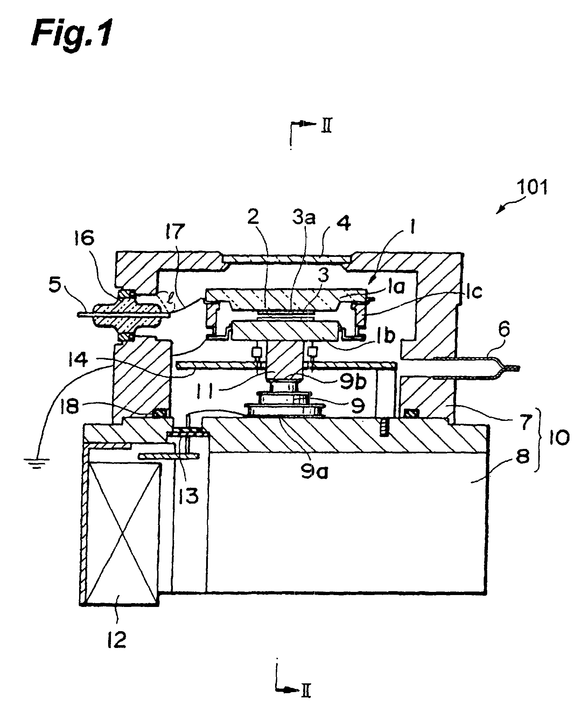

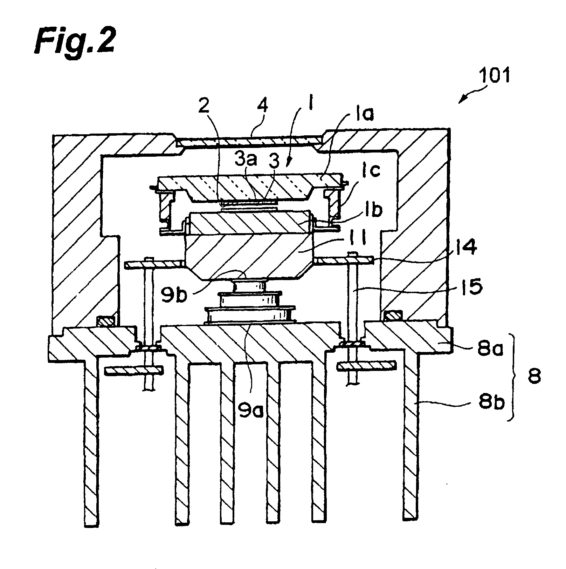

The arrangement of a photodetecting device according to the first embodiment of the present invention will be described first with reference to Figs. 1 and 2. Fig. 1 is a sectional view of an entire photodetecting device 101. Fig. 2 is a sectional view taken along a line II - II of the photodetecting device 101 shown in Fig. 1. This photodetecting device 101 mainly comprises a hermetic vessel 10 constituted by a housing 7 made of stainless steel and radiator 8, a photodetecting section 1 accommodated in the hermetic vessel 10, and Peltier elements 9 as cooling means installed in the hermetic vessel 10.

On the upper surface of the housing 7, i.e., on the measurement light incidence side, a transparent member 4 made of glass is hermetically fixed to the housing 7 with an adhesive. On the side surface of the housing 7, a high-voltage introduction terminal 5 which is made of Kovar and supplies a high voltage to the photodetecting section 1 is hermetically fixed to the housing 7 through an insulting member 16 formed from glass such that one end of the terminal externally projects outside the hermetic vessel 10 while the other end is accommodated in the hermetic vessel 10. To prevent damage, the insulting member 16 uses glass having almost the same thermal expansion coefficient as that of Kovar that forms the high-voltage introduction terminal 5. One end of the high-voltage introduction terminal 5, which is located in the hermetic vessel 10, is electrically connected to a photoelectric surface 2 of the photodetecting section 1 through a conductor wire 17.

On the opposite side surface of the housing 7, a gas introduction port 6 which is made of copper and introduces a dry inert gas into the hermetic vessel 10 is hermetically inserted into the housing 7. The housing 7 is attached to the radiator 8 which also functions as a base member through a vacuum sealing member such as an O-ring 18, thereby forming the hermetic vessel 10. The radiator 8 is formed from a material having a high thermal conductivity (e.g., aluminum) and has radiation fins 8b suspending from a base portion 8a, as shown in Fig. 2. An air cooling fan 12 for cooling the radiator 8 by air is provided outside the radiator 8. A Peltier power supply connector 13 is in tight contact with the side portion of the base portion 8a.

A multiple of Peltier elements 9 as cooling elements are stacked on the upper surface of the radiator 8, i.e., in the hermetic vessel 10. A Peltier element 9 on the lower side in Fig. 1, i.e., on the radiator 8 side serves as a heat generation portion 9a, and a Peltier element 9 on the upper side serves as a heat absorption portion 9b. The Peltier element 9 on the heat generation portion 9a side is connected to the above-described Peltier power supply connector 13. The photodetecting section 1 is mounted on the upper surface of the heat absorption portion 9b through an aluminum member 11 having a high thermal conductivity. The aluminum member 11 need not always be provided.

The photodetecting section 1 is a vessel in which a vacuum space is formed by a disc-like stem 1b, cylindrical valve 1c, and incident surface plate 1a made of glass. The stem 1b and valve 1c are formed from a ceramic with satisfactory thermal conductivity and electrical insulating properties.

The incident surface plate 1a of the photodetecting section 1 has, on its lower surface, the above-described photoelectric surface 2 which emits photoelectrons upon receiving measurement light transmitted through the transparent member 4. The stem 1b has, on its upper surface, a back irradiation type CCD 3 for converting the photoelectrons emitted from the photoelectric surface 2 into a signal voltage. The CCD 3 has an electron incident surface 3a. The electron incident surface 3a opposes the photoelectric surface 2. A circuit board 14 for processing a signal from the CCD 3 is connected to the CCD 3. A signal connector 15 shown in Fig. 2 is connected to the circuit board 14. The electron incident surface 3a of the CCD 3 is set at ground potential.

The photodetecting device 101 of this embodiment is completed by introducing and sealing a dry inert gas in the above-described hermetic vessel 10. The gas is introduced and sealed in the hermetic vessel 10 in the following way. First, air in the hermetic vessel 10 is exhausted from the gas introduction port 6 using a turbo-pump to set a high-vacuum state in the hermetic vessel 10. After that, a dry inert gas (not shown) is introduced from the gas introduction port 6 into the hermetic vessel 10. Then, the gas introduction port 6 is cut by pinch-off to make the cut portion flat and maintain the hermetic state, as shown in Fig. 1, or closed by a valve (not shown), thereby sealing the hermetic vessel 10.

As described above, since a high voltage is applied to the photodetecting section 1, discharge may occur between the conductor wire 17 and the housing 7 to generate a dark current in the photoelectric surface 2. However, the dark current in the photoelectric surface 2 can be prevented by setting the sealed gas at such pressure that no discharge occurs between the conductor wire 17 and the housing 7.

The pressure of the gas sealed in the hermetic vessel 10 is preferably within the range from 100 Torr to atmospheric pressure.

If the gas pressure is much lower than the lower limit of the above-described range, discharge readily occurs between the housing 7 and the conductor wire 17 in the hermetic vessel 10. The reason is as follows.

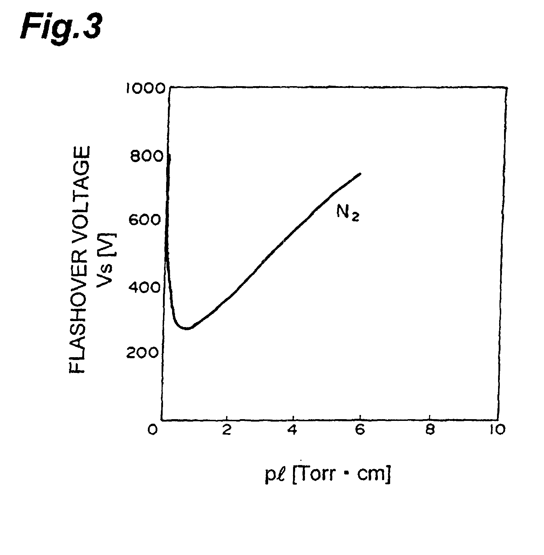

As indicated by the Paschen's curve in Fig. 3, let p [Torr] be the gas pressure, and 1 [cm] be the minimum distance between the housing 7 and the conductor wire 17 of the high-voltage introduction terminal 5. A flashover voltage Vs [V] is represented by a function of pl [Torr. cm] and exhibits an almost V-shaped curve. When the value pl is about 1 [Torr. cm], the flashover voltage Vs [V] is minimum. The tendency of the graph changes from this minimum point. In this embodiment, since the distance 1 is about 0.7 cm, only a region where the value pl is larger than 1 [Torr. cm] need be taken into consideration. In this region, as the value pl becomes small, i.e., as the gas pressure becomes low, the flashover voltage Vs [V] becomes low to readily cause discharge. When the gas pressure is reduced, the molecule density of the sealed gas becomes low. The average free path of electrons becomes long, so the electrons in the field are accelerated to increase the speed. For this reason, collision ionization becomes active, and discharge readily occurs.

On the other hand, if the gas pressure is much higher than the upper limit of the above-described range, heat convection occurs in the hermetic vessel 10. This degrades the cooling effect for the CCD 3 and photoelectric surface 2 and lowers the photodetection efficiency of the photodetecting section 1. In addition, the sealed gas presses the transparent member 4 made of glass.

Hence, when the pressure of the sealed gas is set within the range from 100 Torr to atmospheric pressure, the cooling efficiency can be prevented from becoming low, and discharge can be more properly prevented. However, since the probability of discharge changes depending on the magnitude of the voltage applied to the photodetecting section 1, the pressure of sealed gas must be determined in accordance with the applied voltage.

The function of the photodetecting device of this embodiment will be described next in units of the cooling process and photodetection process of the photodetecting section.

The cooling process of the photodetecting section 1 will be described first with reference to Fig. 1.

When a current flows from the Peltier power supply connector 13 to the Peltier elements 9, the Peltier element 9 on the heat absorption side absorbs heat of the CCD 3 through the aluminum member 11 having a high thermal conductivity and cools the CCD 3. For this reason, the dark current flowing to the transfer section of the CCD 3 decreases, and the sensitivity of the CCD 3 is improved. Since a high voltage is applied to the photodetecting section 1, the temperature of the photoelectric surface 2 increases without the Peltier elements 9. Unwanted thermoelectrons may be emitted from the photoelectric surface 2 to increase the dark current. In this embodiment, however, since the Peltier elements 9 are provided to cool not only the CCD 3 but also the photoelectric surface 2 through the stem 1b and valve 1c which are formed from a ceramic having a satisfactory thermal conductivity, thermoelectrons can be reduced, and the sensitivity of the photoelectric surface 2 can be improved. Since a portion near the incident surface plate 1a is cooled, condensation may occur on the incident surface plate 1a. However, the gas sealed in the hermetic vessel 10 is a dry gas, and therefore, no condensation occurs on the incident surface plate 1a. For this reason, the efficiency of measurement light transmitted through the transparent member 4 and incident on the photoelectric surface 2 can be prevented from lowering.

Heat of the heat generation portion 9a of the Peltier elements 9 is externally radiated from the photodetecting device 101 by the radiator 8. The air cooling fan 12 is arranged near the radiator 8 to further increase the cooling effect of the radiator 8 and, more particularly, the cooling effect for the CCD 3 and photoelectric surface 2, thereby improving the photodetecting effect. The heat of the heat generation portion 9a of the Peltier elements 9 is transferred to the transparent member 4 through the housing 7 made of stainless steel. Since this prevents condensation on the transparent member 4, the efficiency of measurement light incident on the photoelectric surface 2 can be improved.

In addition, since the high-vacuum state in the hermetic vessel 10 need not always be maintained in cooling, a vacuum pump can be omitted. For this reason, the entire apparatus can be made compact for easy handling, and the manufacturing *cost* can also be reduced.

The gas sealed in the hermetic vessel 10 is dry nitrogen gas. Alternatively, argon or xenon gas may be sealed. When argon or xenon gas is used, transmission of external heat of the hermetic vessel 10 by convection decreases because these gases have lower thermal conductivities than the thermal conductivity of nitrogen, and therefore, the cooling efficiency for the photodetecting section 1 is improved.

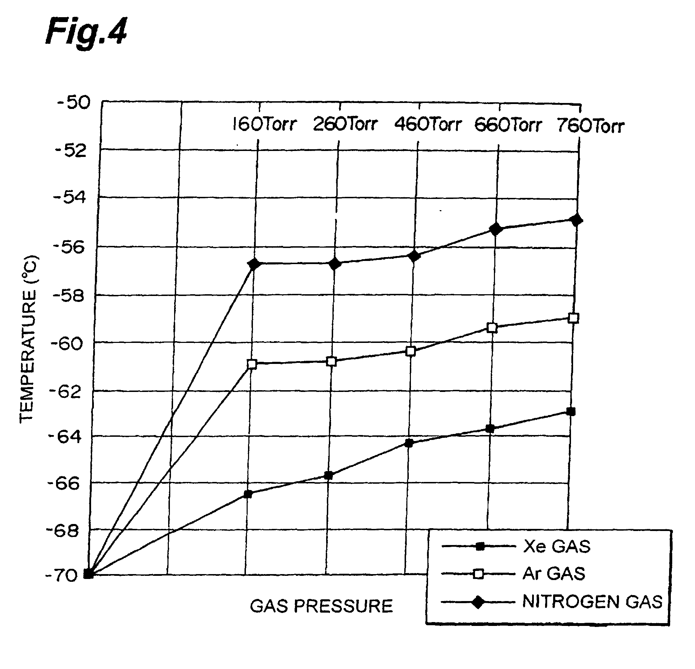

Fig. 4 shows the result of an experiment in which an experimental apparatus having Peltier elements accommodated in a hermetic vessel was prepared independently of this embodiment, and the temperature of the heat absorption portion of the Peltier elements to which a current of 0.8 A was flowed was measured for each of nitrogen, argon, and xenon gases. As is apparent from this graph, the highest cooling effect is obtained when xenon with the lowest thermal conductivity is used.

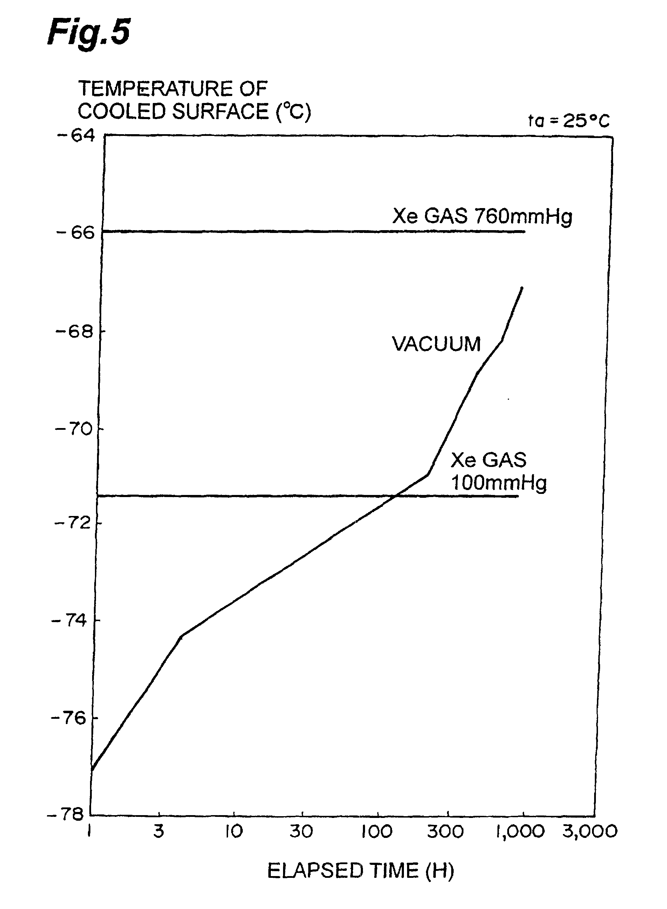

Fig. 5 shows the result of an experiment in which a change in temperature of the heat absorption portion of Peltier elements along the time axis when xenon gas is sealed in the hermetic vessel was measured. As is apparent from this graph, even when the time has elapsed, the cooling effect rarely degrades. As described above, when xenon gas is used, the cooling effect of the Peltier elements 9 can be improved and maintained for a long time. However, to give priority to cost reduction, nitrogen gas is preferably used rather than xenon gas.

The photodetection process of the photodetecting device 101 whose photodetecting efficiency is improved by the above cooling process will be described next with reference to Fig. 1.

When target measurement light is transmitted through the transparent member 4 and the incident surface plate 1a of the photodetecting section 1 and becomes incident on the photoelectric surface 2, electrons in the photoelectric: surface 2 are excited upon absorbing the photon energy [h ν] and emitted into the vacuum as photoelectrons. When a high voltage of about -8 kV is applied from an external high-voltage power supply to the photoelectric surface 2 through the high-voltage introduction terminal 5, the photoelectrons emitted from the photoelectric surface 2 are attracted to the CCD 3 side because the electron incident surface 3a of the CCD 3 is grounded. The photoelectrons attracted to the CCD 3 side reach the CCD 3 and are converted into signal charges, and then, converted into a signal voltage by the output section of the CCD 3. The signal voltage is processed by the circuit board 14 and output through the signal connector 15.

Since the photoelectric surface 2 and CCD 3 are cooled by the Peltier effect of the Peltier elements 9 to increase the sensitivity, weak light or UV light can be detected, unlike a conventional photodetecting device which has a photoelectric surface without a cooling unit, and an electron incidence type semiconductor element. Even when a high voltage is applied to the photodetecting section 1, no dark current is generated in the photoelectric surface 2 due to the influence of discharge because an inert gas is sealed in the hermetic vessel 10 at a pressure lower than atmospheric pressure and, more specifically, such a pressure that no discharge occurs. For this reason, the high sensitivity state of the photodetecting section 1 by the cooling function of the Peltier elements 9 is rarely damaged.

### [Second Embodiment]

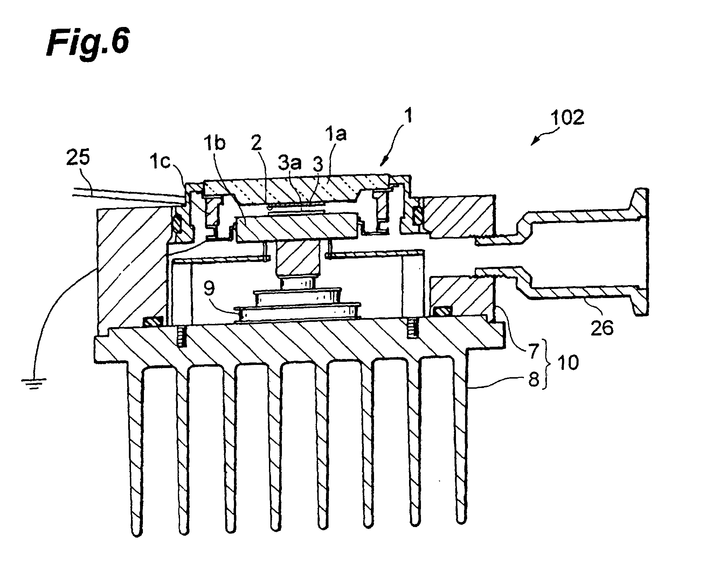

A photodetecting device according to the second embodiment of the present invention will be described next with reference to Fig. 6. A photodetecting device 102 of this embodiment is different from a photodetecting device 101 of the first embodiment in that an incident surface plate 1a of a photodetecting section 1 is in contact with air, a high-voltage cable 25 projecting outside a hermetic vessel 10 is provided instead of the high-voltage introduction terminal 5 and conductor wire 17 as a mechanism for applying a voltage to a photoelectric surface 2, and a vacuum port 26 for setting a vacuum state in the hermetic vessel 10 is arranged in place of the gas introduction port 6. When the photodetecting device 102 is operating, air in the hermetic vessel 10 is exhausted from the vacuum port 26 by a vacuum pump (not shown), so the vacuum state is set in the hermetic vessel 10.

In this embodiment as well, a CCD 3 and photoelectric surface 2 are cooled by the function of Peltier elements 9, and the photodetecting efficiency can be improved, as in the first embodiment. In addition, since the high-voltage cable 25 for applying a voltage to the photoelectric surface 2 projects into air, no discharge occurs in the hermetic vessel 10. Furthermore, since the degree of vacuum can be increased, the cooling efficiency can be improved.

The first embodiment is more practical than the second embodiment because condensation may occur on the air-side surface of the incident surface plate 1a of the photodetecting section 1 when cooled, and the entire apparatus becomes bulky due to the vacuum pump which is always provided.

### [Third Embodiment]

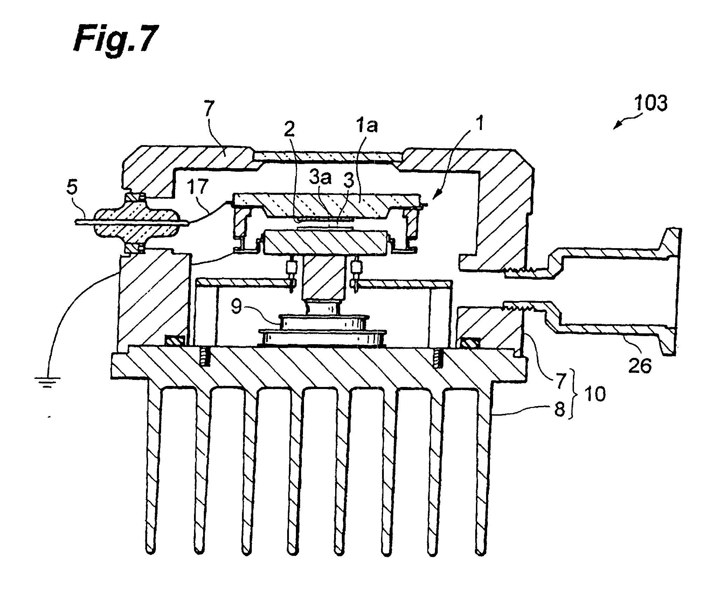

A photodetecting device according to the third embodiment of the present invention will be described next with reference to Fig. 7. A photodetecting device 103 of this embodiment is different from a photodetecting device 101 of the first embodiment in that a vacuum port 26 for setting the vacuum state in a hermetic vessel 10 is formed in place of the gas introduction port 6. When the photodetecting device 103 is operating, air in the hermetic vessel 10 is exhausted from the vacuum port 26 by a vacuum pump (not shown), so the vacuum state is set in the hermetic vessel 10.

In this embodiment as well, a CCD 3 and photoelectric surface 2 are cooled by the function of Peltier elements 9, and the photodetecting efficiency can be improved, as in the first embodiment. In addition, since the degree of vacuum can be increased, the cooling efficiency can be improved.

The third embodiment is more practical than the second embodiment because condensation does not occur on the upper surface of an incident surface plate 1a, i.e., the surface on the side without the photoelectric surface 2. However, the first embodiment is more practical than the third embodiment because the entire apparatus becomes bulky due to the vacuum pump which is always provided.

### [Image Sensing Apparatus]

A CCD camera 111 as an image sensing apparatus having a photodetecting device 101 of the first embodiment will be described next.

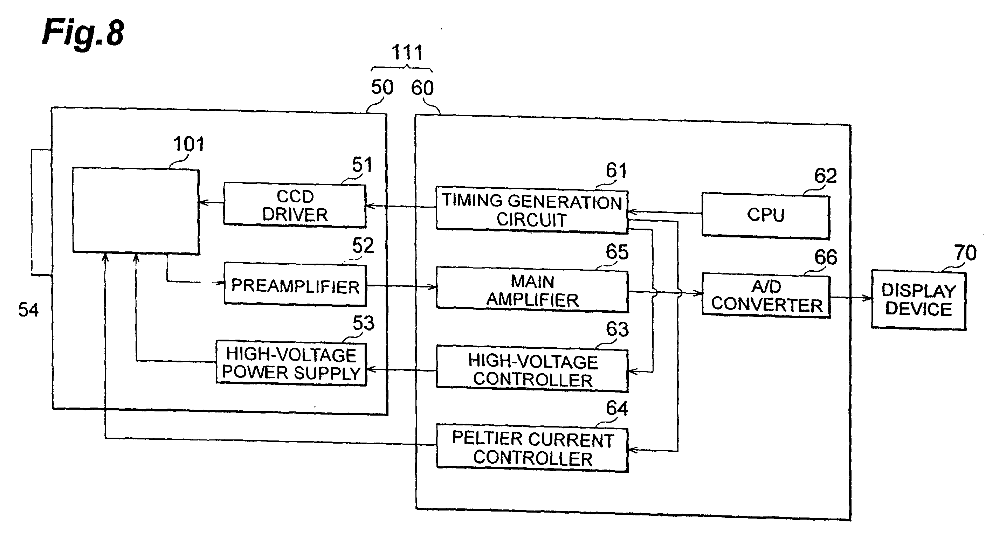

Fig. 8 is a block diagram of the CCD camera 111. The aluminum member 11 comprises a camera head 50 incorporating the photodetecting device 101 of the first embodiment and a camera controller 60 for controlling the photodetecting device 101. The camera head 50 accommodates not only the photodetecting device 101 but also a CCD driver 51 for driving a CCD 3 in the photodetecting device 101, a preamplifier 52 for amplifying the output from the CCD 3, and a high-voltage power supply 53 for applying a high voltage to a photoelectric surface 2 in the photodetecting device 101 through a high-voltage introduction terminal 5. A condenser lens 54 is arranged on the incidence side of the photodetecting device 101.

The camera controller 60 has a timing generation circuit 61 for outputting a timing signal for controlling the CCD driver 51, a CPU 62 for controlling the timing generation circuit 61, and a high-voltage controller 63 for controlling the high-voltage power supply 53, a Peltier current controller 64 for controlling a current of Peltier elements 9 in the photodetecting device 101, a main amplifier 65 for amplifying the output from the preamplifier 52, and an A/D converter 66 for converting the output from the main amplifier 65 into a digital signal. The A/D converter 66 is connected to an external display device 70 having a control function.

In this arrangement, an output signal read from the CCD 3 of the photodetecting device 101 is amplified by the preamplifier 52 and main amplifier 65, sent to the A/D converter 66, and then converted into a digital signal. After that, the signal is transmitted to the external display device 70 having a control function, subjected to predetermined signal processing, and displayed on the display device. The CCD camera 111 incorporates the photodetecting device 101 with a high photodetecting efficiency and therefore has a very high sensitivity.

An image sensing apparatus having the photodetecting device 101 of the first embodiment has been described above. A photodetecting device 103 of the second embodiment can also be used.

The invention made by the present inventors has been described above in detail on the basis of the embodiments. However, the present invention is not limited to the above embodiments. For example, the arrangement of the CCD camera 111 can be appropriately changed. The invention is, however, limited by the scope of the accompanying claims only.

### Industrial Applicability

As has been described above, in the photodetecting device of the present invention, the semiconductor detection element side of the vacuum vessel is cooled, and a dark current in the semiconductor detection element is suppressed. In addition, not only the semiconductor detection element but also the photoelectric surface is cooled through the vacuum vessel in which the semiconductor detection element and photoelectric surface are arranged. For this reason, a dark current in the photoelectric surface is also suppressed, and the photodetecting efficiency is improved.

## Claims

1. A photodetecting device (101) comprising a housing (7), light transparent means (4) located on the housing for allowing the passage of light into the housing, the housing including vacuum means for evacuating the housing to a vacuum state, photodetecting means (I) located within the housing so as to receive thereon light passing through the light transparent means (4) and to emit photoelectrons from a photoelectric surface (2) thereof in accordance with the amount of light incident thereon, a semiconductor detection element (1b) including an electron incident surface (3a) spaced from and facing photoelectric surface (2) of the photodetecting means for receiving photoelectrons emitted from the photodetecting means so as to emit an electrical signal in accordance with the amount of photoelectrons incident upon the semiconductor detection element, a voltage terminal (5) mounted on the housing (7) being electrically connected to the photo detecting means for applying a high voltage between the photoelectric surface (2) and the electron incident surface of the semiconductor detection element, cooling means (9) for cooling the semiconductor detection element, the said cooling means including a heat absorption portion for absorbing heat and a heat generation portion (9a) for generating heat, **characterised by** said heat absorption portion being arranged on the semiconductor detection element and said heat generation portion (9a) of said cooling means being fixed at a predetermined position on an inner surface of said housing;
and by a gas introduction part (6) through which a dry inert gas has been introduced into said housing, said dry inert gas being sealed in the housing at a pressure lower than atmospheric pressure.

2. A photodetecting device according to claim 1, wherein said housing (7) further comprises radiation means (8) for radiating heat, said radiation means being arranged at the predetermined position where said heat generation portion (9a) of said cooling means (9) is fixed.

3. A photodetecting element according to claim 1 or 2, wherein said vacuum vessel (10) comprises an incident surface plate (3a) which passes the light and has said photoelectric surface (2) arranged on one surface, a detection element fixing plate opposing said incident surface plate so as to face each other and having said semiconductor detection element arranged thereon, and a tube which forms a vacuum space together with said incident surface plate and said detection element fixing plate.

4. A photodetecting element according to claim 3, wherein said tube and said detection element fixing plate (2) are formed from a ceramic material.

5. A photodetecting element according to any of claims 1 to 4, wherein said cooling means (9) comprises a Peltier element.

6. An image sensing apparatus **characterized by** comprising said photodetection element of any of claims 1 to 5.

## Patentansprüche

1. Photodetektorvorrichtung (101) mit einem Gehäuse (7), einer an dem Gehäuse angeordneten lichtdurchlässigen Einrichtung (4), um den Durchgang von Licht in das Gehäuse zu ermöglichen, wobei das Gehäuse eine Vakuumeinrichtung zur Evakuierung des Gehäuses in einen Vakuumzustand aufweist, einer innerhalb des Gehäuses angeordneten Photodetektoreinrichtung (1), um darauf durch die lichtdurchlässige Einrichtung (4) durchgelaufenes Licht zu empfangen, und um von ihrer photoelektrischen Oberfläche (2) entsprechend der darauf einfallenden Lichtmenge Photoelektronen zu emittieren, einem Halbleitererfassungselement (1b) mit einer Elektroneneinfallsoberfläche (3a), die im Abstand zu und zugewandt zu einer photoelektrischen Oberfläche (2) der Photodetektoreinrichtung liegt, zum Empfang von von der Photodetektoreinrichtung emittierten Photoelektronen, um ein elektrisches Signal gemäß der Menge von auf das Halbleitererfassungselement einfallenden Photoelektronen abzugeben, einem an dem Gehäuse (7) angebrachten Spannungsanschluss (5), der elektrisch mit der Photodetektoreinrichtung verbunden ist, um zwischen der photoelektrischen Oberfläche (2) und der Elektroneneinfallsoberfläche des Halbleitererfassungselements eine Hochspannung anzulegen, einer Kühlungseinrichtung (9) zum Kühlen des Halbleitererfassungselements, wobei die Kühlungseinrichtung einen Wärmeabsorptionsabschnitt zum Absorbieren von Wärme und einen Wärmeerzeugungsabschnitt (9a) zur Erzeugung von Wärme aufweist,
**dadurch gekennzeichnet dass**
der Wärmeabsorptionsabschnitt an dem Halbleitererfassungselement angeordnet ist und der Wärmeerzeugungsabschnitt (9a) der Kühlungseinrichtung bei einer vorbestimmten Position an einer inneren Oberfläche des Gehäuses fixiert ist; und **gekennzeichnet durch** ein Gaseinführungsbauteil (6), **durch** den ein trockenes Inertgas in das Gehäuse eingeführt wurde, wobei das trockene Inertgas in dem Gehäuse mit einem geringeren Druck als Atmosphärendruck versiegelt wird.

2. Photodetektorvorrichtung nach Anspruch 1, wobei das Gehäuse (7) zudem eine Abstrahlungseinrichtung (8) zum Abstrahlen von Wärme aufweist, wobei die Abstrahlungseinrichtung an der vorbestimmten Position angeordnet ist, in der der Wärmeerzeugungsabschnitt (9a) der Kühlungseinrichtung (9) fixiert ist.

3. Photodetektorelement nach Anspruch 1 oder 2, wobei das Vakuumgefäß (10) eine Einfallsoberflächenplatte (3a) aufweist, die das Licht durchlässt und die auf einer Oberfläche angeordnete photoelektrische Oberfläche (2) aufweist, eine Erfassungselementfixierplatte aufweist, die der Einfallsoberflächenplatte gegenüberliegt, so dass sie einander zugewandt sind und wobei das Halbleitererfassungselement darauf angeordnet ist, und eine Röhre aufweist, die zusammen mit der Einfallsoberflächenplatte und der Erfassungselementfixierplatte einen Vakuumraum bildet.

4. Photodetektorelement nach Anspruch 3, wobei die Röhre und die Erfassungselementfixierplatte (2) aus einem keramischen Material gebildet sind.

5. Photodetektorelement nach einem der Ansprüche 1 bis 4, wobei die Kühlungseinrichtung (9) ein Peltier-Element aufweist.

6. Bildsensorvorrichtung,
**dadurch gekennzeichnet, dass**
sie das Photodetektorelement nach einem der Ansprüche 1 bis 5 aufweist.

## Revendications

1. Dispositif de photodétection (101) comprenant un boîtier (7), un moyen transparent à la lumière (4) situé sur le boîtier en vue de permettre le passage de la lumière dans le boîtier, le boîtier comprenant un moyen de réalisation de vide destiné à évacuer le boîtier vers un état de vide, un moyen de photodétection (1) situé à l'intérieur du boîtier de façon à recevoir sur celui-ci la lumière traversant le moyen transparent à la lumière (4) et à émettre des électrons photoélectriques depuis une surface photoélectrique (2) de celui-ci conformément à la quantité de lumière incidente sur celui-ci, un élément de détection à semiconducteur (1b) comprenant une surface d'incidence d'électrons (3a) espacée et en regard de la surface photoélectrique (2) du moyen de photodétection en vue de recevoir des électrons photoélectriques émis depuis le moyen de photodétection de façon à émettre un signal électrique conformément à la quantité d'électrons photoélectriques incidents sur l'élément de détection à semiconducteur, une borne de tension (5) montée sur le boîtier (7) étant électriquement reliée au moyen de photodétection en vue d'appliquer une haute tension entre la surface photoélectrique (2) et la surface d'incidence d'électrons de l'élément de détection à semiconducteur, un moyen de refroidissement (9) destiné à refroidir l'élément de détection à semiconducteur, ledit moyen de refroidissement comprenant une partie d'absorption de chaleur destinée à absorber la chaleur et une partie de génération de chaleur (9a) destinée à générer de la chaleur, **caractérisée par** ladite partie d'absorption de chaleur qui est agencée sur l'élément de détection à semiconducteur et ladite partie de génération de chaleur (9a) dudit moyen de refroidissement qui est fixée à une position prédéterminée sur une surface intérieure dudit boîtier,
et par une partie d'introduction de gaz (6) à travers laquelle un gaz inerte sec a été introduit dans ledit boîtier, ledit gaz inerte sec étant enfermé de façon étanche dans le boîtier à une pression inférieure à la pression atmosphérique.

2. Dispositif de photodétection selon la revendication 1, dans lequel ledit boîtier (7) comprend en outre un moyen de rayonnement (8) destiné à rayonner de la chaleur, ledit moyen de rayonnement étant agencé à la position prédéterminée où ladite partie de génération de chaleur (9a) dudit moyen de refroidissement (9) est fixée.

3. Elément de photodétection selon la revendication 1 ou 2, dans lequel ladite enceinte à vide (10) comprend une plaque de surface d'incidence (3) qui transmet la lumière et comporte ladite surface photoélectrique (2) agencée sur une surface, une plaque de fixation d'élément de détection opposée à ladite plaque de surface d'incidence de façon à être en regard l'une de l'autre et comportant ledit élément de détection à semiconducteur agencé sur celle-ci, et un tube qui forme un espace sous vide en association avec ladite plaque de surface d'incidence et ladite plaque de fixation d'élément de détection.

4. Elément de photodétection selon la revendication 3, dans lequel ledit tube et ladite plaque de fixation d'élément de détection (2) sont formés à partir d'un matériau de céramique.

5. Elément de photodétection selon l'une quelconque des revendications 1 à 4, dans lequel ledit moyen de refroidissement (9) comprend un élément à effet Peltier.

6. Dispositif de détection d'image **caractérisé en ce qu'**il comprend ledit élément de photodétection selon l'une quelconque des revendications 1 à 5.
